(19) Europäisches Patentamt / European Patent Office / Office européen des brevets

(11) **EP 3 414 367 B1**

(12) **EUROPEAN PATENT SPECIFICATION**

(45) Date of publication and mention of the grant of the patent:
**26.02.2020 Bulletin 2020/09**

(51) Int Cl.:
*H01L 21/324* (2006.01)   *H01L 29/36* (2006.01)
*C30B 29/06* (2006.01)   *C30B 31/08* (2006.01)
*C30B 31/20* (2006.01)   *H01L 21/261* (2006.01)

(21) Application number: **17703166.3**

(22) Date of filing: **08.02.2017**

(86) International application number:
**PCT/EP2017/052754**

(87) International publication number:
**WO 2017/137438 (17.08.2017 Gazette 2017/33)**

(54) **A PHOSPHORUS DOPED SILICON SINGLE CRYSTAL**

PHOSPHORDOTIERTER SILICIUMEINKRISTALL

MONOCRISTAL DE SILICIUM DOPÉ AU PHOSPHORE

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: **08.02.2016 EP 16154695**

(43) Date of publication of application:
**19.12.2018 Bulletin 2018/51**

(73) Proprietor: **Topsil GlobalWafers A/S**
**3600 Frederikssund (DK)**

(72) Inventors:
• **SVEIGAARD, Theis Leth**
**2860 Søborg (DK)**
• **GRÆSVÆNGE, Martin**
**2820 Gentofte (DK)**
• **HINDRICHSEN, Christian Gammeltoft**
**2880 Bagsværd (DK)**
• **DUUN, Sune Bo**
**3520 Farum (DK)**
• **LEI, Anders**
**2400 Copenhagen NV (DK)**

(74) Representative: **AWA Denmark A/S**
**Strandgade 56**
**1401 Copenhagen K (DK)**

(56) References cited:
WO-A1-2012/089392    DE-A1- 19 738 732
DE-A1-102004 034 372    DE-A1-102010 028 924
JP-B2- 5 283 543

• MYONG-SEOP KIM ET AL: "Estimation of future demand for neutron-transmutation-doped silicon caused by development of hybrid electric vehicle and its supply from research reactors", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8 September 2009 (2009-09-08), pages 1-10, XP031541330, ISBN: 978-1-4244-4432-8
• Iaea: "Neutron Transmutation Doping of Silicon at Research Reactors", , 1 May 2012 (2012-05-01), XP055293346, Austria ISBN: 978-92-0-130010-2 Retrieved from the Internet: URL:http://www-pub.iaea.org/MTCD/Publicati ons/PDF/TE_1681_web.pdf [retrieved on 2016-08-03]
• S J Park ET AL: "IAEA-TM-38728 (2010) 1 NEUTRON TRANSMUTATION DOPING IN HANARO REACTOR", , 1 July 2013 (2013-07-01), XP055293394, Austria Retrieved from the Internet: URL:http://www-pub.iaea.org/MTCD/Publicati ons/PDF/SupplementaryMaterials/TECDOC_171 3 _CD/template-cd/datasets/papers/ParkSJ NTD Silicon HANARO Jun2010.pdf [retrieved on 2016-08-03]
• WANG ET AL: "Resistivity distribution of silicon single crystals using codoping", JOURNAL OF CRYSTAL GROWTH, ELSEVIER, AMSTERDAM, NL, vol. 280, no. 3-4, 1 July 2005 (2005-07-01), pages 408-412, XP027849429, ISSN: 0022-0248 [retrieved on 2005-07-01]

EP 3 414 367 B1

- ALIMANNSHOFER L ET AL: "A material innovation for the electronic industry: Float zone single crystal silicon with 200mm diameter", 2003 IEEE 15TH. INTERNATIONAL SYMPOSIUM ON POWER SEMICONDUCTOR DEVICES AND IC'S PROCEEDINGS. CAMBRIDGE, UIK, APRIL 14 - 17, 2003; [INTERNATIONAL SYMPOSIUM ON POWER SEMICONDUCTOR DEVICES & IC'S], NEW YORK, NY : IEEE, US, 14 April 2003 (2003-04-14), pages 325-328, XP010653788, DOI: 10.1109/ISPSD.2003.1225293 ISBN: 978-0-7803-7876-6

**Description**

**Field of the invention**

The present invention relates to phosphorus doped silicon single crystals, a method of producing a phosphorus doped silicon single crystal, a plurality of wafers and a silicon wafer. The phosphorus doped silicon single crystal has a dopant density allowing that wafers having improved radial resistivity variation (RRV) values are cut from the phosphorus doped silicon single crystal. The silicon wafers of the invention are particularly suited for use in high power electronics.

**Prior art**

Single crystal rods of semiconductor materials, such as silicon, are typically produced using one of two general methods, the Czochralski (CZ) method or the float-zone (FZ) method. Both of these are well-known and rely upon the formation of a single crystal during resolidification of molten material. Silicon single crystals are used as a starting material for preparation of silicon wafers, which are cut from the silicon single crystal.

Depending on application the silicon wafer can be described with, and may need a specific value of the resistivity, which is expressed in e.g. $\Omega$cm or corresponding units. The resistivity, $\rho$, of silicon depends on the dopant density, e.g. phosphorus and/or boron, in the material and their relation is described in Equation (1):

$$\text{Equation (1)} \qquad n = \frac{1}{\rho \mu_m q}$$

where $n$ is the density of phosphorus atoms (and boron atoms are considered to be present in insignificant amounts from the raw material, e.g. less than 10 ppta), $\mu_m$ electron mobility in silicon and $q$ is electronic charge. The value of $q$ is $1.602 \cdot 10^{-19}$ C, and the typical value of $\mu_m$, e.g. at room temperature, is 1450 cm$^2$/s. Since the dopant atoms employed in silicon will normally be phosphorus and/or boron the resistivity of silicon may be controlled by controlling the amount of phosphorus and boron atoms in the silicon. Dopant atoms may be applied to the silicon material during production of the silicon single crystal. For example, phosphorus and boron may be applied by exposing the molten silicon to gaseous phosphine ($PH_3$) or diboran ($B_2H_6$), respectively, so that the respective atoms are included in the silicon upon the resolidification. This process is generally known as gas doping. It is noted that other gases may be applied, but phosphine and diboran are the most commonly used in industry.

Alternatively, silicon atoms in solid silicon can be converted to phosphorus atoms by irradiating the material with neutrons. Specifically, when the isotope $^{30}$Si is irradiated with neutrons it will be transmuted to the isotope $^{31}$Si, which decays, with a half life of 2.6 h, to the stable phosphorus isotope $^{31}$P. Natural silicon has about 3% $^{30}$Si, and irradiation with neutrons can therefore be used to increase the density of phosphorus donor atoms in silicon. This process is known as neutron transmutation doping (NTD). The necessary dose of neutrons, or fluence, in the following denoted $D$, can be calculated from Equation (2):

$$\text{Equation (2)} \qquad D = K_1 \left( \frac{1}{\rho_{NTD}} - \frac{1}{\rho_i} \right)$$

where $K_1$ is a material constant for a given neutron spectrum, and $\rho_{NTD}$ and $\rho_i$ are the resistivities after NTD irradiation and the initial resistivity, i.e. before neutron irradiation, respectively. The constant $K_1$ is defined in Equation (3):

$$\text{Equation (3)} \qquad K_1 = \frac{1}{N^{30Si} \sigma^{30Si} \mu_m q}$$

where $N^{30Si}$ is the density of $^{30}$Si in the silicon and $\sigma^{30Si}$ is the average absorption cross-section of $^{30}$Si. With the above values of $q$ and $\mu_m$, $K_1$ will be $2.612 \cdot 10^{19}$ $\Omega$cm$^{-1}$.

The resistivity of a silicon wafer may vary across the surface of the silicon wafer, both due to stochastic variation and also due to systematic variations caused by the procedure used to include the doping atoms in the silicon. The quality of a wafer, and thereby also of a single crystal from which the wafer is cut, can be described by the resistivity distribution of the material where a homogenous resistivity throughout the cross-section of the single crystal equals high quality. The homogeneity of the resistivity of silicon is typically classified for a silicon wafer using the RRV value, which is defined (according to the SEMI standard SEMI MF81) in Equation (4):

Equation (4)     $$RRV = \frac{\rho_{max} - \rho_{min}}{\rho_{min}} 100\%$$

where $\rho_{max}$ is the highest resistivity and $\rho_{min}$ is the lowest resistivity recorded for a wafer. In order to determine the RRV value for a wafer several resistivity values are recorded over the surface of the wafer, which corresponds to the cross-section of the single crystal from which the wafer was cut. NTD treatment is generally considered to provide the best distribution of phosphorus donor atoms commonly yielding RRV values of about 5-7% or less. However, for large silicon crystals, e.g. with diameters above 150 mm, the neutron irradiation will not be even through the cross-section of the diameter, due to absorption of the neutrons penetrating the silicon ingot.

The RRV value is a combined value for a silicon wafer (including both stochastic and systematic variation) but any systematic variation across the surface of the wafer is likely not visible in the RRV value. NTD and gas doping both have systematic variations in the distribution of phosphorus atoms in the silicon single crystal.

A NTD process is performed in a nuclear reactor designed to irradiate a crystal of a length of e.g. up to about 600 mm. The reactor includes a neutron source and is typically designed to provide the crystal with neutrons from a slit, which is parallel to the axis of the crystal so that a transverse plane in the crystal can be considered to be exposed to a point shaped source of neutron irradiation. The history of NTD of silicon is summarised in IAEA-TECDOC-1681 (Vienna 2012) from the International Atomic Energy Agency (ISBN 978-92-0-130010-2), and practical application of the NTD process is described in Topsil Semiconductor Materials' Application Note "Neutron Transmutation Doped (NTD) Silicon For High Power Electronics" (October 2013), which can be found on: http://www.topsil.com/media/56052/ntd application note long version october 2013.pdf. Further discussions of NTD processes and their recent development are provided by Kim *et al.* (2009, Estimation of future demand for neutron-transmutation-doped silicon caused by development of hybrid electric vehicle and its supply from research reactors, 13th European Conference on Power Electronics and Applications, 2009. EPE '09, pp. 1-10) and Park et al. (2013, Neutron transmutation doping in HANARO reactor, http://www-pub.iaea.org/MTCD/Publications/PDF/SupplementaryMaterials/TECDOC 1713 CD /template-cd/datasets/papers/ParkSJ%20NTD%20Silicon%20HANARO%20Jun2010.pdf).

The crystal is rotated in the reactor during exposure to the irradiation in order to ensure an even distribution of neutron flux. However, silicon has a decay length of about 19 cm, and therefore for crystals of large diameters, e.g. above 150 mm, the edge of the crystal will be exposed to a larger fluence than the centre of the crystal, thereby resulting in an uneven distribution of phosphorus donor atoms. NTD treated silicon wafers of 200 mm diameter are available from Topsil GlobalWafers A/S as evident from the company's website. Topsil Semiconductor Materials' Application Note "200mm <100> NTD Silicon Wafers For High Power" (February 2014), discloses examples of 200 mm diameter silicon wafers treated in the NTD process, where the RRV is less than 7%. Typically, the resistivity profiles show a systematic deviation where the resistivity is higher near the centre, corresponding to a lower fluence, than near the edge where the resistivity is closer to the target resistivities. This systematic effect is more pronounced for lower target resistivities which are obtained using a higher fluence as can be seen from Equation (2). A further example of NTD treatment of a large diameter silicon single crystal is provided in DE 102010028924. Silicon single crystals of 200 mm diameter were prepared in a CZ process before irradiating to provide radial resistivities of 50 Ωcm from which wafers with RRV values down to 2.5% were cut.

Where NTD treatment will result in a higher fluence near the edge of a crystal of high diameter, and thereby a higher density of dopant atoms near the edge, gas based doping processes will generally result in a higher density of dopant atoms near the centre of the single crystal.

DE 102004034372 discloses a process for the manufacture of a silicon single crystal where gas doping is employed in a FZ step to provide a first electrical resistance of the single crystal followed by a neutron irradiation treatment to provide a second electrical resistance. The object of DE 102004034372 is to provide a method for producing a silicon single crystal, where the dispersion of electrical resistance in a plane is low, at a low cost and high productivity, even if the electrical resistance is low. The Examples of DE 102004034372 disclose the FZ manufacture of silicon single crystals with diameters of 125 mm where gas doping using phosphine provides first resistances of 25 to 65 Ωcm and where subsequent NTD treatment provides the target resistances of 15 Ωcm or 17 Ωcm. RRV values down to 1.8% are reported for the process for 125 mm wafers. The neutron irradiation in DE 102004034372 can be performed in a light water reactor or a heavy water reactor, and since the single crystal is rotated it is considered uniformly irradiated.

It is an object of the present invention to provide a phosphorus doped silicon single crystal having a large diameter and an even density of phosphorus dopant atoms across the cross-section allowing improved silicon wafers to be prepared from the phosphorus doped silicon single crystal.

## Disclosure of the invention

The present invention relates to a phosphorus doped silicon single crystal having a diameter in the range of 175 mm to 225 mm and an axial length in the range of 50 mm to 1000 mm, an oxygen content below $2\cdot10^{16}$ cm$^{-3}$, the phosphorus doped silicon single crystal in a transverse plane having a density of dopant atoms providing a target resistivity ($\rho_{NTD}$) in the range of 55 $\Omega$cm to 2000 $\Omega$cm for a wafer cut from the phosphorus doped silicon ingot, wherein a RRV value of 2% or less as determined according to the SEMI standard SEMI MF81 is obtained for at least 75% of wafers cut from the phosphorus doped silicon single crystal when the resistivity is measured after annealing the silicon at a temperature in the range of 800°C to 1300°C. For example, the invention relates to a phosphorus doped silicon single crystal having a diameter of at least 175 mm and an axial length in the range of 50 mm to 600 mm. The phosphorus doped silicon single crystal in a transverse plane has a density of dopant atoms providing a target resistivity ($\rho_{NTD}$) in the range of 55 $\Omega$cm to 2000 $\Omega$cm for a wafer cut from the phosphorus doped silicon ingot, wherein 5 or more resistivity values, in particular 9 or 10 measurements according to the SEMI standard SEMI MF81, recorded across the surface of the silicon wafer after annealing provide an average resistivity $\rho_{av}$ and the normalised average resistivity defined as $\rho_{av}/\rho_{NTD}$ is in the range of 0.95 to 1.05, when the resistivity is measured after annealing the silicon at a temperature in the range of 800°C to 1300°C. The deviation from $\rho_{NTD}$ should be calculated for at least 10 wafers, and it is preferred that the normalised average resistivity, $\rho_{av}/\rho_{NTD}$, in the range of 0.95 to 1.05 is observed for at least 10 wafers, e.g. at least 20 wafers or more preferably all wafers cut from a silicon single crystal. The normalised average resistivity, $\rho_{av}/\rho_{NTD}$, may also be classified relative to the number of wafers cut from a silicon single crystal. In an embodiment of the invention the normalised average resistivity, $\rho_{av}/\rho_{NTD}$, is in the range of 0.95 to 1.05, e.g. 0.96 to 1.04, for at least 75%, e.g. at least 80%, at least 90% or at least 95%, of the wafers cut from a silicon single crystal.

The upper limit of the RRV that the specified percentage of wafers is below may also be referred to as the "upper specific limit" (USL), in particular when 95% of the wafers are below this limit. Thus, when a wafer having a RRV value of 1.8% or less is cut from the phosphorus doped silicon single crystal, the USL of the phosphorus doped silicon single crystal will typically be 4% or lower, e.g. 3% or lower, or 2% or lower. Both the RRV and $\rho_{av}/\rho_{NTD}$ for a plurality of wafers cut from a phosphorous doped silicon single crystal of the invention may also be described in terms of the standard deviation observed from the respective value for the plurality of wafers. In particular, the average RRV value plus three standard deviations may be set as the USL and for $\rho_{av}/\rho_{NTD}$ the USL may also be three standard deviations above 0% (i.e. from the target resistivity); likewise a "lower specific limit" (LSL) exists for $\rho_{av}/\rho_{NTD}$, which may be three standard deviations below 0%. In a specific embodiment the plurality of wafers thus has an USL of 4% for the RRV (corresponding to the average RRV value plus three standard deviations), e.g. 3%, but the majority of the wafers will have RRV values below 1.8%, or even below 1.5%. In another embodiment the plurality of wafers as an USL of 5%, e.g. 4%, for the normalised average resistivity, $\rho_{av}/\rho_{NTD}$, which thus corresponds to three standard deviations, and a LSL of -5%, e.g. -4%, corresponding to minus three standard deviations, so that $\rho_{av}/\rho_{NTD}$ is in the range of 0.95 to 1.05, e.g. 0.96 to 1.04.

The phosphorus doped silicon single crystals have a diameter in the range of 175 mm to 225 mm. Also disclosed is that the diameter of the phosphorus doped silicon single crystal is in the range of 275 mm to 325 mm. In specific embodiments the phosphorus doped silicon single crystals have a diameter in the range of 175 mm to 225 mm and an oxygen content below $2\cdot10^{16}$ cm$^{-3}$. Also disclosed are phosphorus doped silicon single crystals having a diameter above 250 mm, e.g. in the range of 275 mm to 325 mm, and an oxygen content below $2\cdot10^{16}$ cm$^{-3}$. Further disclosed are phosphorus doped silicon single crystals having a diameter in the range of 275 mm to 325 mm and an oxygen content above $10^{17}$ cm$^{-3}$. The phosphorus doped silicon single crystals can have any crystal orientation, e.g. <100> or <111>.

In another aspect the invention relates to a plurality of wafers cut from the phosphorus doped silicon single crystal. In an embodiment each of the wafers of the plurality has a RRV value below 2%, such as at or below 1.8% or at or below 1.5%. In another embodiment the plurality of wafers has an USL for the RRV of 4%. The term "plurality" in the context of the invention is at least 2 but preferably at least 3, at least 4, at least 5, at least 6, at least 7, at least 8, at least 9, at least 10, at least 20, at least 30, at least 40, at least 50, at least 100 etc. In an embodiment the wafers of the plurality of wafers will have a normalised average resistivity, $\rho_{av}/\rho_{NTD}$, in the range of 0.95 to 1.05 when the average resistivity $\rho_{av}$ is calculated from 5 or more, e.g. 9 or 10, resistivity values recorded across the surface of the wafers. The resistivities may be obtained according to the SEMI standard MF81, although other procedures may also be employed. In other embodiments each of the wafers of the plurality of wafers has a normalised average resistivity, $\rho_{av}/\rho_{NTD}$, in the range of 0.96 to 1.04, such as 0.97 to 1.03. In particular the USL and the LSL, when defined as explained above, may be $\pm5\%$, or $\pm4\%$, or $\pm3\%$, respectively. The plurality of wafers may also have been subjected to an annealing step at a temperature in the range of 800°C to 1300°C. The wafers of the plurality of wafers will generally have a thickness in the range of 100 $\mu$m to 2000 $\mu$m, such as 500 $\mu$m to 1000 $\mu$m, 1200 $\mu$m to 1800 $\mu$m, or 200 $\mu$m to 500 $\mu$m. Thus, a typical silicon single crystal of the invention will yield at least 50 wafers.

Also disclosed is a wafer cut from the phosphorus doped silicon single crystal. The wafer may also have been subjected to an annealing step at a temperature in the range of 800°C to 1300°C. The wafer will generally have a thickness in the range of 100 $\mu$m to 2000 $\mu$m, such as 500 $\mu$m to 1000 $\mu$m, 1200 $\mu$m to 1800 $\mu$m, or such as 200 $\mu$m to 500 $\mu$m. Exemplary wafer thicknesses are about 700 $\mu$m and about 1400 $\mu$m.

The present inventors have found that for a NTD apparatus the ratio between the irradiation dose, $D$, and the phosphorus donor density excess created during the NTD process at the edge of the irradiated single crystal, or ingot, compared to the centre of the silicon single crystal is constant. This relation is expressed in Equation (5) as the constant, $K_2$:

$$\text{Equation (5)} \qquad K_2 = \frac{\Delta n_{NTD,ec}}{D}$$

where $\Delta n_{NTD,ec}$ is the phosphorus donor density excess created during the NTD process at the edge of the irradiated single crystal compared to the centre of the silicon single crystal, which is defined in Equation (6):

$$\text{Equation (6)} \qquad \Delta n_{NTD,ec} = \left(n_{NTD.e} - n_{i,e}\right) - \left(n_{NTD,c} - n_{i,c}\right)$$

where $n_{NTD,e}$ and $n_{NTD,c}$ are the phosphorus donor densities at the edge and the centre after irradiation, respectively, and $n_{i,e}$ and $n_{i,c}$ are the initial phosphorus donor densities at the edge and the centre, respectively.

The present inventors have further found that for a gas based doping process, in particular for a gas based doping float-zone (FZ) process, the distribution of the dopant atoms, e.g. the phosphorus donor atoms, will also be constant with respect to the density of phosphorus donor atoms introduced into the centre of the single crystal formed during resolidification compared to the density of phosphorus donor atoms at another location, e.g. near the edge of the resolidified silicon single crystal. This constant may be expressed according to Equation (7):

$$\text{Equation (7)} \qquad K_3 = \frac{n_{i,c} - n_{i,e}}{n_{i,AVG}}$$

where $n_i$ denotes phosphorus donor densities obtained in the gas doping process, so that $n_{i,c}$ and $n_{i,e}$ are the phosphorus donor densities at the centre and at the edge of the silicon single crystal, and $n_{i,AVG}$ is the average value. Since the gas doping process is performed before the NTD treatment the i will also refer to the "initial" value for the NTD process.

The constants $K_2$ and $K_3$ can be determined for a specific reactor and a specific gas doping process, respectively. The values $n_{i,c}$ and $n_{NTD,c}$ may be recorded in a region comprising the centre but are not limited to the exact centre of the silicon single crystal, and likewise the values $n_{i,e}$ and $n_{NTD,e}$ may be recorded at a specified distance from the centre, as long as data collected for a number of silicon wafers are collected in the same way for all wafers included in the determination of $K_2$ and $K_3$. For example, $n_{i,c}$ and $n_{NTD,c}$ may be recorded at a distance from the centre to 10% of the radius of the single crystal. Likewise, $n_{i,e}$ and $n_{NTD,e}$ may be recorded at a distance from the centre e.g. from 80% to 100% of the radius of the single crystal. It is contemplated that the constant $K_3$ is relevant for both FZ type processes and also for Czochralski (CZ) type processes.

The present inventors have now surprisingly found that when gas doping and NTD are combined to produce a silicon single crystal of a large diameter, e.g. above 150 mm, in particular in the range of 175 mm to 350 mm, the constants $K_2$ and $K_3$ can be used to calculate the resistivity needed in the gas doping process, $\rho_i$, expressed as an initial resistivity or pre-irradiation resistivity with respect to the NTD process step from the desired target resistivity, $\rho_{NTD}$, and that determining the resistivities needed in the gas doping process using this relation will result in a more even distribution of phosphorus atoms in the irradiated silicon single crystal, which can be seen as a RRV value (as determined according to the SEMI standard SEMI MF81) at or below 1.8% for silicon wafers cut from the irradiated silicon single crystal, or which can be seen as an RRV value of 3% or less is obtained for at least 75% of wafers cut from the phosphorus doped silicon single crystal. The relation between the constants $K_2$ and $K_3$ is most appropriately used when the target resistivity ($\rho_{NTD}$) is in the range of 5 Ωcm to 2000 Ωcm. By using the method of the invention the radial shape of the resistivity profile of the gas based process step, i.e. as expressed with the constant $K_3$, is taken into consideration when planning the NTD step, i.e. as expressed with the constant $K_2$, so that the resistivity profiles even each other out, and a consistently lower RRV is, and correspondingly lower RRV values are, provided for wafers cut from the phosphorus doped silicon single crystal than is available using either process step alone. The RRV value will typically be below 6% for all wafers cut from the phosphorus doped silicon single crystal. For example, wafers can be cut from the phosphorus doped silicon single crystal, which have RRV values at or below 1.7%, or at or below 1.6%, or at or below 1.5%, or at or below 1.4%, or at or below 1.3%, or at or below 1.2%, or at or below 1.1%, or at or below 1.0%. In particular, a phosphorus doped silicon single crystal thus prepared allows that at least 75% of wafers cut from the phosphorus doped silicon single crystal will have a RRV value at or below 3%, e.g. below 2%, or at least 50% of wafers cut from the phosphorus doped silicon single crystal will have a RRV value at or below 2%, such as at or below 1.8% or at or below 1.5%. The relation between the constants $K_2$ and $K_3$ further allows that the normalised average resistivity, $\rho_{av}/\rho_{NTD}$, is in the range of 0.95 to 1.05 for a significant proportion, e.g. at least 75%, at least 95% and up to 100% of the wafers cut from a silicon single crystal.

For gas based doping processes the resistivity, $\rho_i$, will generally be provided as a single value for the silicon ingot produced, despite it that the resistivity may vary across the cross-section(s) of the silicon ingot produced. The steps required for obtaining a selected resistivity, $\rho_i$, in a gas based doping process is well-known to the skilled person. The above relation is found to be particularly relevant for a phosphorus doped silicon single crystal having high target resistivities, e.g. at or above 100 Ωcm, and in a preferred embodiment the phosphorus doped silicon single crystal has a target resistivity in the range of 100 Ωcm to 1200 Ωcm. The higher the target resistivity the lower the amount of phosphorus atoms needed in the silicon single crystal and therefore it is more important to control the distribution of the phosphorus atoms when high resistivities, e.g. above 100 Ωcm, are required. The present invention especially provides better control of the distribution of phosphorus atoms when the target resistivity is at or above 100 Ωcm.

The relation between the resistivity $\rho_i$ (the pre-irradiation resistivity) and the target resistivity $\rho_{NTD}$ can generally be considered linear for a specific gas doping process coupled with a specific NTD process, and the ratio of the relation will typically be in range of 1/6 to 1/3. Thus, when target resistivity $\rho_{NTD}$ is about 100 Ωcm the pre-irradiation resistivity $\rho_i$ may be in the range 300 Ωcm to 600 Ωcm, and when the target resistivity $\rho_{NTD}$ is about 1000 Ωcm the pre-irradiation resistivity $\rho_i$ may be in the range 3000 Ωcm to 6000 Ωcm. The relation between $\rho_{NTD}$, $\rho_i$, $K_2$, and $K_3$ may be expressed according to Equation (8):

$$\text{Equation (8)} \qquad \rho_{NTD} = \rho_i \left( \frac{K_3}{K_2 K_1 \mu_m q} + 1 \right)^{-1}$$

In another aspect the invention relates to a method of producing a phosphorus doped silicon single crystal having a predetermined target resistivity ($\rho_{NTD}$) in the range of 5 Ωcm to 2000 Ωcm, which target resistivity is measurable after annealing a wafer cut from the phosphorus doped silicon single crystal, the method comprising the steps of:

gas doping of molten silicon in a crucible free process or in a crucible in the presence of a phosphorus containing gaseous species,
solidifying the molten silicon so as to form a gas doped silicon single crystal having a pre-irradiation resistivity ($\rho_i$) and a diameter of 175 mm or more,
irradiating the gas doped silicon single crystal with neutrons to decrease the resistivity to the target resistivity ($\rho_{NTD}$), e.g. from the pre-irradiation resistivity ($\rho_i$),
wherein the target resistivity ($\rho_{NTD}$) is selected and a RRV of 6% or less is obtained by pre-selecting the gas doping conditions and the irradiation conditions according to Equation (8).

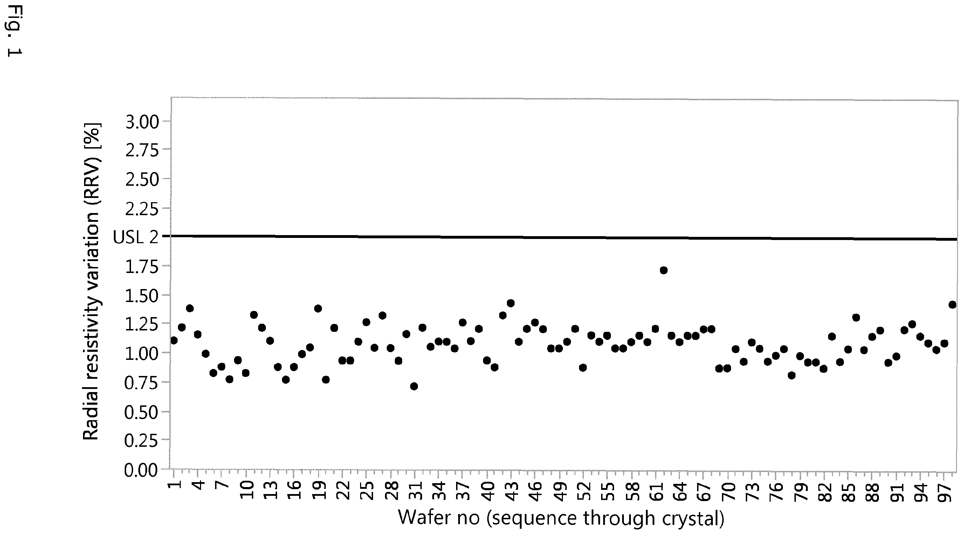

It is evident from the definitions of $K_2$ (Equation (5) and Equation (6)) and $K_3$ (Equation (7)) that the constants take account of the radial variation of the radial distribution of the dopant atoms obtained in the NTD treatment and the gas doping process, respectively. The present inventors have surprisingly found that the constants, when used in Equation (8), allow planning of the NTD treatment based on a specific gas doping process, or vice versa, which is described using its constant $K_3$, so that a consistently lower RRV, expressed with the RRV value, is obtained for wafers cut from the silicon single crystal produced according to the invention than can be obtained using either of the gas doping or the NTD treatment alone. It is especially noted that when producing a phosphorus doped silicon single crystal in the method of the invention little concern is needed to ensure that an even radial distribution of the dopant atoms is obtained in the gas doping, since the characterisation of the specific process by $K_3$ is included in Equation (8) where it is matched to the NTD process. Gas doped silicon single crystals with specific radial distribution profiles of phosphorus doping are available from Topsil GlobalWafers A/S. The Application Note "200 mm <100> PREFERRED FLOAT ZONE (PFZ) SILICON WAFERS" (Sune Duun, Anne Nielsen, Christian Hindrichsen, Theis Sveigaard, Ole Andersen, Jarosław Jabłoński, and Leif Jensen, September 2014, http://www.topsil.com/media/142195/pfz application note 200mm september2 014.pdf) thus shows radial resistivity profiles of exemplary gas doped silicon single crystals (see Fig. 1) from which $K_3$ can be calculated; the Application Note, especially Fig. 1 thereof, is incorporated herein by reference.

The method of the invention allows that lower RRV values are obtained than is afforded by NTD treatment without gas doping, e.g. the RRV values will always be below 6%. The RRV values will typically be below 4%, e.g. for at least 95%, such as for 100%, of the wafers cut from the phosphorus doped silicon single crystal. In certain embodiments, a RRV value of 3% is obtained, e.g. for at least 75%, e.g. at least 90%, of the wafers cut from the phosphorus doped silicon single crystal. In other embodiments a RRV value of at 2% or less, such as 1.8% or less, is obtained. The method further provides a phosphorus doped silicon single crystal from which the resistivity values recorded for wafers, e.g. at least 75% of the wafers, cut from the silicon single crystal after annealing have an average resistivity $\rho_{av}$ and a normalised average resistivity defined as $\rho_{av}/\rho_{NTD}$ in the range of 0.95 to 1.05, such as in the range of 0.96 to 1.04, for example when the resistivities are recorded according to the SEMI standard SEMI MF81.

The crucible free process may be any process in which a silicon single crystal is prepared from a silicon material, e.g. a polycrystalline silicon, where the silicon material is not molten in a crucible. A preferred crucible free process is a FZ method. The silicon material may also be molten in a crucible, and any appropriate method may be used.

When a silicon single crystal is prepared by melting in a crucible the process may also be referred to as a CZ method. A silicon single crystal produced in a CZ process using gas doping may have a different distribution profile compared to a silicon single crystal produced using gas doping in a FZ process. However, the difference in radial distribution profiles will be reflected in the constant $K_3$, which is used in Equation (8) and the combined process will be carried out accordingly so that a consistently lower RRV is obtained than is available by either gas doping or NTD treatment alone. A CZ process will typically provide an axial variation in the distribution of dopant atoms. By combining gas doping in a CZ process with NTD according to the present invention it is possible to ensure an even transverse distribution of phosphorous dopant atoms, however, it is preferred that a CZ pre-irradiation ingot is divided into subsections and subsequently neutron irradiating each subsection separately in order to achieve a desired target resistivity for the subsection. For example, a CZ crystal may be prepared with 2 to 6, e.g. 3 or 4, sections of a predefined resistivity, and in an embodiment of the method of the invention the CZ crystal is cut into the subsections of predefined resistivity before exposing each subsection to NTD treatment in order to obtain different target resistivities for the subsections. Each subsection thus produced will have an even axial, as well as an even transverse, distribution of phosphorus dopant atoms. The subsections may have a length in the range of 50 mm to 1000 mm, e.g. 50 mm to 600 mm, or the subsections may be shorter.

Gas doping processes are well-known to the skilled person, and it is within his skills to prepare a silicon ingot having a desired pre-irradiation resistivity ($\rho_i$). The gas doping may be performed with any phosphorus containing gaseous species that can be used in a gas doping process. For example, the gas doping may be performed using phosphine ($PH_3$).

The fluence required to obtain $\rho_{NTD}$ can be calculated from Equation (2). It is within the knowledge of the skilled person to device a set-up of a NTD reactor and determine $K_2$ for the NTD reactor. The method of the invention may further comprise the step of determining the constant $K_2$ for a NTD reactor. The method may also comprise the step of determining the constant $K_3$, e.g. for a specific gas based doping process. The constants $K_2$ and $K_3$ are relevant for specific process types, and they will therefore be determined with some uncertainty, e.g. expressed as a standard deviation. The RRV values may be predicted from the above equations. In a specific example, $K_2$ was determined to be $4.280 \cdot 10^{-6}$ cm$^2$ and $K_3$ was determined to be 0.10 (so that the ratio for this specific combination is 0.165). When these values of $K_2$ and $K_3$ are used to predict the RRV of a 200 mm wafer including three standard deviations in the calculation the RRV value for the wafer will be below 3%, e.g. at or below 2%, or at or below 1.8%, which demonstrates the utility of the relation expressed in Equation (8). RRV values below 2%, e.g. below 1.8%, were demonstrated experimentally as explained below.

The phosphorus doped silicon single crystals of the invention, e.g. a phosphorus doped silicon single crystal prepared according to the method of the invention, are typically described by the RRV value obtained for a wafer cut from the phosphorus doped silicon single crystal but the phosphorus doped silicon single crystal may also be described using the normalised average resistivity, $\rho_{av}/\rho_{NTD}$, defined above. The RRV value, and also the $\rho_{av}/\rho_{NTD}$, reflect the distribution of phosphorus donor atoms introduced into the silicon during the processing so that the phosphorus doped silicon single crystal may also be described with the distribution of phosphorus donor atoms, in particular the distribution of phosphorus donor atoms in a transverse plane of the phosphorus doped silicon single crystal. Any method may be used to measure the distribution of phosphorus atoms in the phosphorus doped silicon single crystal. In order to estimate the distribution of phosphorus donor atoms a wafer may be cut from the phosphorus doped silicon single crystal, and the wafer may then be exposed to annealing conditions before recording resistivity values. The step of annealing a silicon wafer cut from the phosphorus doped silicon single crystal will be performed according to the standard methods in the field, as known to the skilled person, e.g. by exposing the silicon wafer to a temperature in the range of 800°C to 1300°C. Annealing of a silicon wafer will remove defects created in the silicon material by the neutron irradiation. An embodiment of the method further comprises the step of cutting a wafer from the phosphorus doped silicon single crystal and optionally also annealing the wafer at a temperature in the range of 800°C to 1300°C. However, the distribution of phosphorus atoms in the phosphorus doped silicon single crystal may be determined using any appropriate method, and it is not necessary to cut a wafer from the phosphorus doped silicon single crystal; it is also not necessary to anneal it in order to estimate the distribution of phosphorus atoms by recording resistivities across the surface of the wafer.

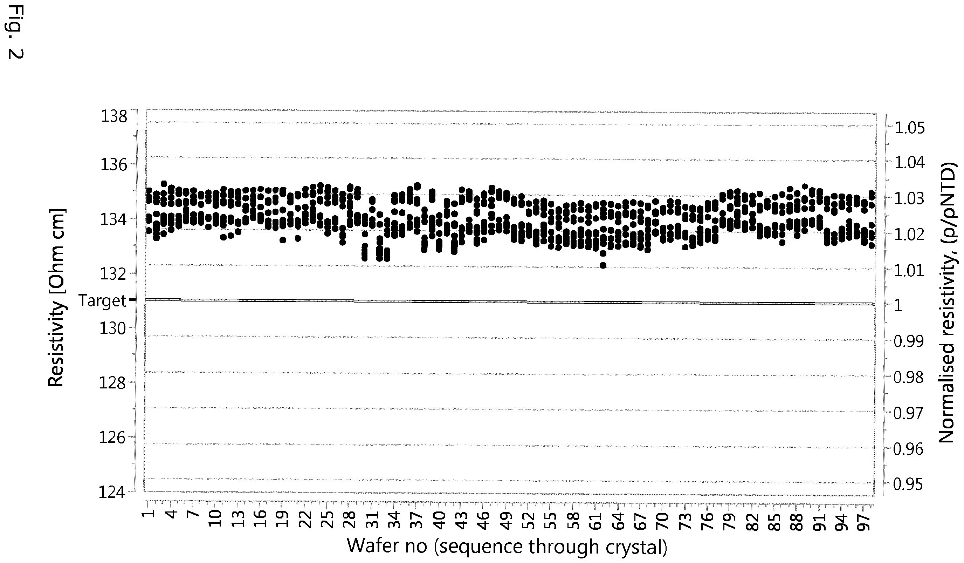

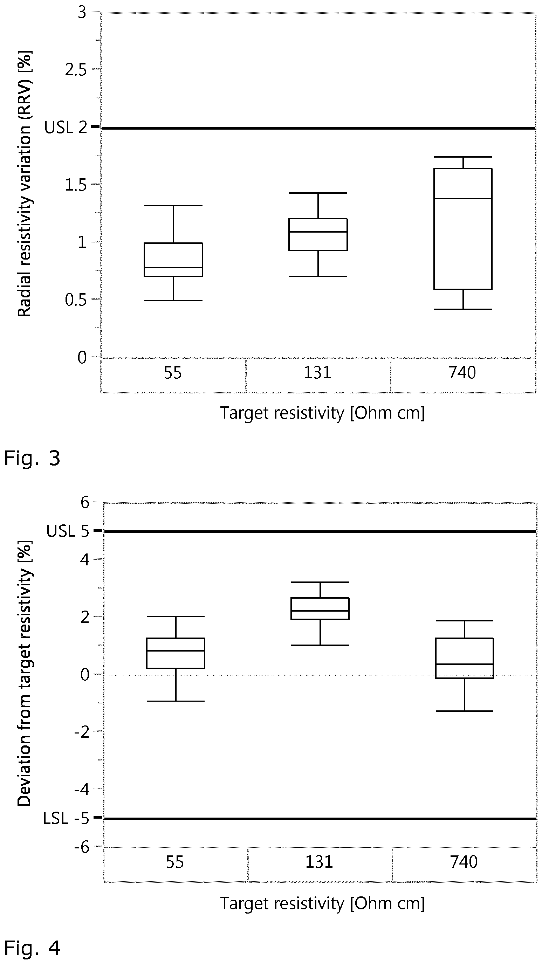

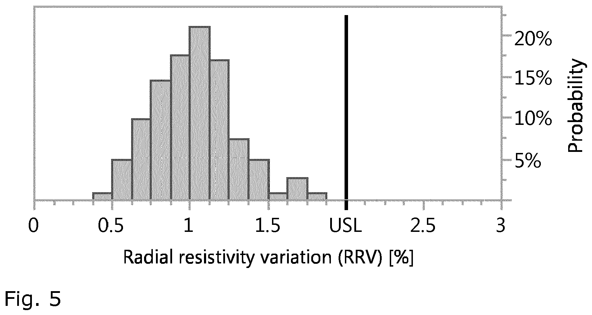

In general, the variation of RRV values obtained from silicon wafers prepared according to prior art methods typically allow that single outlier wafers are identified, which have even very low RRV values, e.g. less than 3%. The phosphorus doped silicon single crystal of the invention advantageously has a more even distribution of phosphorus atoms also in the axial direction of the phosphorus doped silicon single crystal. Thus, the phosphorus doped silicon single crystal allows that a RRV value of 2% or less, is obtained for at least 75% of the wafers cut from the phosphorus doped silicon single crystal. Moreover, the phosphorus doped silicon single crystal allows that a RRV value of 4% or less is obtained for at least 95%, e.g. for all, of the wafers cut from the phosphorus doped silicon single crystal. In specific embodiments, the RRV value of 3% may be obtained for at least 80%, or at least 90%, and up to 100% of the wafers cut from the phosphorus doped silicon single crystal. In particular, when 10 or more wafers, e.g. 20 or more wafers or 30 or more wafers, are cut from the phosphorus doped silicon single crystal. It is considered especially advantageous that the phosphorus doped silicon single crystal provides that a RRV value below 4% may be obtained for all of the wafers cut from the phosphorus doped silicon single crystal and that according to the present invention a RRV value below 2% is provided for at least 75% of the wafers cut from the phosphorus doped silicon single crystal. In a specific embodiment a RRV value of 2% or less is obtained for at least 80%, or at least 90%, or at least 95%, or at least 98%, and up to 100% of the wafers cut from the phosphorus doped silicon single crystal. In a further embodiment a RRV value of 1.8% or less is obtained for at least 30% of the wafers cut from the phosphorus doped silicon single crystal, such as at least 40%, at least 50%, or at least 60%, or at least 70%, or at least 80%, or at least 90%, or at least 95%, or at least 98%, and up to 100% of the wafers cut from the phosphorus doped silicon single crystal. For example, a phosphorus doped silicon single crystal of the invention prepared in a FZ process to have a diameter of 200 mm and a target resistivity of 131 $\Omega$cm was cut into 98 wafers, which were labelled with serial numbers for traceability. The wafers were analysed for RRV values according to the SEMI standard SEMI MF81, and all wafers had RRV values below 1.8%. The RRV values are depicted in Figure 1. Deviations from the target resistivity, expressed as the normalised resistivities $\rho/\rho_{NTD}$, are depicted in Figure 2. For this phosphorus doped silicon single crystal 100% of the wafers had RRV values below 1.8%, 99% had RRV values below 1.5%, 97% had RRV values below 1.4%, and 92% had RRV values below 1.3%. Likewise, silicon single crystals were prepared with target resistivities of 55 $\Omega$cm and 740 $\Omega$cm, and all wafers cut from these silicon single crystals had RRV values below 1.8% (see Figure 3 and Figure 5, respectively). Furthermore, the wafers had normalised average resistivity values, $\rho_{av}/\rho_{NTD}$, within the range of 0.96 to 1.04, and for target resistivities of 55 $\Omega$cm and 740 $\Omega$cm within 0.98 to 1.02 (see Figure 4).

The method of the invention advantageously allows a more even distribution of phosphorus donor atoms in the phosphorus doped silicon single crystal, in particular in a transverse plane of the phosphorus doped silicon single crystal but also along the axial dimension of the phosphorus doped silicon single crystal. The more even distribution of phosphorus atoms can be classified by any appropriate means, and as an alternative to calculating the RRV value the quality of a silicon wafer, i.e. as reflected by the even distribution of phosphorus donor atoms in a transverse plane, may also be estimated by taking into consideration all the measurement points recorded for the RRV calculations. The SEMI MF81 standard at present includes obtaining 9 resistivity measurements at specified locations, and instead of using only the highest and the lowest values recorded, as done in the calculation of the RRV, an average value, $\rho_{av}$, can be calculated from the obtained data points. Likewise, a standard deviation may also be calculated from the obtained data points. The average value, $\rho_{av}$, and also the standard deviation, may be normalised to the target resistivity, $\rho_{NTD}$. In an aspect of the invention, the silicon wafer after annealing has a normalised average resistivity defined as $\rho_{av}/\rho_{NTD}$ in the range of 0.95 to 1.05, e.g. in the range of 0.96 to 1.04, or 0.97 to 1.03, or 0.98 to 1.02, or 0.99 to 1.01. The resistivity measurements included in the calculations of the average value, $\rho_{av}$, may be obtained from any pattern of measurements distributed over the surface of the wafer, although in general at least 5 measurements are needed to estimate the average value, $\rho_{av}$, of the resistivity. In a specific embodiment, the resistivity of a wafer is measured at the centre of the wafer (1 or 2 measurements), and 4 measurements distributed along, e.g. evenly distributed along, a circle having a radius of 50% of the radius of the wafer and 4 measurements distributed along, e.g. evenly distributed along, a circle having a radius of 95% to 100% of the radius of the wafer, for example at a distance of 6 mm from the edge of the wafer (when 1 measurement is obtained for the centre of the wafer, 4 measurements are obtained at half the radius and 4 measurements are obtained at 6.0 mm from the edge of the wafer the measurements comply with the SEMI MF81 standard) are recorded, and an average value, $\rho_{av}$, is calculated from the 9 or 10 measurements together with a standard deviation. For a phosphorus doped silicon single crystal produced according to the method of the invention 98 wafers were cut and analysed for variation of the average resistivity for each wafer (according to the SEMI MF81 standard), and all wafers had a normalised average resistivity $\rho_{av}/\rho_{NTD}$, in the range of 0.96 to 1.04 as depicted in Figure 2 and Figure 4. Moreover, when the average resistivity of each wafer was compared to the average resistivity for all the wafers the ratios of the average resistivities for individual wafers to the average resistivity for the population of wafers were in the range of 0.99 to 1.01.

The data in the Figures demonstrate an extremely low wafer-to-wafer variation. For example, the average of the average values, $\rho_{av}$, for the population of wafers obtained from a single phosphorus doped silicon single crystal will typically also be low, e.g. $\pm1\%$ from the average of the $\rho_{av}$'s (data not shown). This extremely low wafer-to-wafer variation is also reflected in the $\rho_{av}/\rho_{NTD}$ and it documents that a $\rho_{av}/\rho_{NTD}$ in the range of 0.95 to 1.05 is obtained, in particular for all wafers cut from the silicon single crystals. In Figure 2 the data is presented as measured resistivity values compared to the target resistivity of 131 $\Omega$cm, $\rho/\rho_{NTD}$. The resistivity values of all wafers are within 5% from the target resistivity.

Furthermore, an USL as well as a "lower specification limit" (LSL) may also be defined for the normalised

average $\rho_{av}/\rho_{NTD}$, which USL and LSL take into account the stochastic variation of the resistivity values recorded for the wafers and the USL may be set to be the $\rho_{NTD}$ plus three standard deviations and the LSL may be set to the $\rho_{NTD}$ minus three standard deviations, where the standard deviations are for all wafers included in the measurements. Other limits for the USL and LSL may be five standard deviations. The plot in Figure 2 shows, for each wafer, the resistivity measurements made according to the SEMI MF81 standard, and the plots in Figure 4 represent the same data as in Figure 2 shown as a box plot with an USL and a LSL, which, at $\pm 5\%$, are within plus or minus three standard deviations, respectively. Figure 4 also shows box plots for phosphorus doped silicon single crystals with target resistivities, $\rho_{NTD}$, of 55 $\Omega$cm and 740 $\Omega$cm. It is evident that the present invention provides a phosphorus doped silicon single crystal from which wafers can be cut, which phosphorus doped silicon single crystal provides an USL of plus 5%, e.g. plus 3%, for the RRV values for wafers cut from the silicon single crystal. Alternatively, a measurement may be made to represent a central region of the wafer corresponding to a distance from the centre to 25% of the radius of the wafer, and two or more resistivity values may be recorded for a region of the wafer corresponding to a distance from 25% of the radius of the silicon wafer to 75% of the radius of the silicon wafer, and two or more resistivity values may be recorded at a distance from 75% of the radius of the silicon wafer to 100% of the radius of the silicon wafer. The phosphorus doped silicon single crystal has a distribution of phosphorus donor atoms allowing a wafer, or a plurality of wafers, to be cut from the phosphorus doped silicon single crystal, which wafer, or a plurality of wafers, after annealing at a temperature in the range of 800°C to 1300°C has a RRV value of 1.8% or less, and also a normalised average resistivity defined as $\rho_{av}/\rho_{NTD}$ in the range of 0.95 to 1.05.

In a certain aspect the invention relates to a phosphorus doped silicon single crystal having a diameter of at least 175 mm and an axial length in the range of 50 mm to 600 mm, the phosphorus doped silicon single crystal in a transverse plane having a density of dopant atoms providing a target resistivity ($\rho_{NTD}$) in the range of 55 $\Omega$cm to 2000 $\Omega$cm for a wafer, or a plurality of wafers, cut from the phosphorus doped silicon ingot, which target resistivity is measurable after annealing the silicon at a temperature in the range of 800°C to 1300°C, wherein the silicon wafer, or the plurality of silicon wafers, after annealing has, or have, a normalised average resistivity defined as $\rho_{av}/\rho_{NTD}$ in the range of 0.95 to 1.05 when 5 or more, e.g. 9 or 10, resistivity values are recorded across the surface of the wafer, e.g. according to the SEMI standard SEMI MF81 or as outlined above. In this aspect the RRV value will generally be below 2% for the wafers, e.g. at or below 1.8%.

In a specific embodiment the silicon ingot is prepared in a FZ process, and the diameter of the silicon ingot, and thereby also of the phosphorus doped silicon single crystal, is in the range of 175 mm to 225 mm. However, the invention is not limited with respect to the diameter of the silicon single crystal, and the relation expressed in Equation (8) is relevant also for silicon single crystals with diameters larger than 225 mm, e.g. 275 mm or larger, or at 350 mm or larger. An appropriate process for the manufacture of such a silicon ingot is described in WO 2008/125104; in particular the section from p. 4, line 9 to p. 5, line 25, e.g. p. 4, line 14-23, and p. 4, line 34 to p. 5, line 5, discloses important parameters for the FZ manufacture of silicon single crystals with diameters in the range of 175 mm to 225 mm. Another method of producing a large diameter silicon single crystal is disclosed in DK 177854 (also published as US 2003/024469). When the silicon ingot is prepared in a FZ process the oxygen content will generally be low, e.g. less than $2 \cdot 10^{16}$ cm$^{-3}$.

In another embodiment the silicon ingot is prepared in a CZ process. Appropriate processes for the manufacture of silicon ingots in CZ processes are described in EP 2824222 and US 2015/240380. When the phosphorus doped silicon single crystal is prepared in a CZ process the diameter of the phosphorus doped silicon single crystal may be in the range of 275 mm to 475 mm. In an embodiment, a CZ process may provide a silicon ingot with a diameter in the range of 275 mm to 325 mm. Silicon ingots prepared in a CZ process can generally be recognised from the oxygen content, which is typically above $10^{17}$ cm$^{-3}$.

Equation (8) is not considered limited with respect to the diameter of the phosphorus doped silicon single crystal, and it is also contemplated that Equation (8) applies for diameters larger than 450 mm. In particular, the diameter is determined by the method of manufacture of the silicon ingot. In an embodiment the silicon ingot is prepared in a FZ process to have a diameter in the range of 175 mm to 225 mm, and in another embodiment the silicon ingot is prepared in a FZ process to have a diameter in the range of 275 mm to 325 mm. In still further embodiments the silicon ingot is prepared in a CZ process to have a diameter in the range of 275 mm to 325 mm, or in the range of 375 mm to 425 mm, or in the range of 425 mm to 475 mm.

In another aspect the invention relates to a phosphorus doped silicon single crystal obtainable in the method of the invention. In particular, the phosphorus doped silicon single crystals of the aspects described above are obtainable in the method of the invention. In yet another aspect the invention relates to a wafer cut from a phosphorus doped silicon single crystal obtainable in the method of the invention. In yet a further aspect the invention relates to a plurality of wafers cut from a phosphorus doped silicon single crystal obtainable in the method of the invention.

Also disclosed is a silicon wafer, and a further embodiment of the invention relates to a plurality of wafers, having a diameter in the range of 175 mm to 225 mm, a thickness in the range of 100 $\mu$m to 1500 $\mu$m, a resistivity in the range of 55 $\Omega$cm to 2000 $\Omega$cm, a RRV value below 2% e.g. at 1.8% or less, and an oxygen content below $2 \cdot 10^{16}$ cm$^{-3}$; the silicon wafer(s) has/have a normalised average resistivity defined as $\rho_{av}/\rho_{NTD}$ in the range of 0.95 to 1.05, e.g.

in the range of 0.96 to 1.04. Also disclosed is a silicon wafer, or a plurality of wafers, having a diameter in the range of 275 mm to 325 mm, a resistivity in the range of 5 $\Omega$cm to 2000 $\Omega$cm, a RRV value of 2% or less, and an oxygen content above $10^{17}$ cm$^{-3}$; the silicon wafer(s) has/have a normalised average resistivity defined as $\rho_{av}/\rho_{NTD}$ in the range of 0.95 to 1.05, e.g. in the range of 0.96 to 1.04.

In general all variations and features for any aspect and embodiment of the invention may be combined freely. The features described above for the phosphorus doped silicon single crystals are thus equally relevant for the method of the invention and also for the wafer of the invention.

**Brief description of the figures**

In the following the invention will be explained in greater detail with the aid of an example and with reference to the schematic drawings, in which

Figure 1 shows RRV values recorded for wafers cut from a phosphorus doped silicon single crystal of the invention.
Figure 2 shows a plot of resistivities for wafers cut from a phosphorus doped silicon single crystal of the invention.
Figure 3 shows box plots of RRV values for wafers cut from phosphorus doped silicon single crystals of the invention.
Figure 4 shows box plots of normalised average resistivities for wafers cut from phosphorus doped silicon single crystals of the invention.
Figure 5 shows a pooled distribution of RRV values recorded for wafers cut from phosphorus doped silicon single crystals of the invention.

**Detailed description of the invention**

The present invention relates to phosphorus doped silicon single crystals, a plurality of wafers cut from the phosphorus doped silicon single crystal and a method of producing a phosphorus doped silicon single crystal.

In the context of the invention the "phosphorus doped silicon single crystal" is a silicon single crystal, which has been doped with phosphorus to control the phosphorus density in the crystal and thereby the resistivity. In the method of the invention the phosphorus doped silicon single crystal is exposed to neutron irradiation in a neutron transmutation doping (NTD) process. The phosphorus doped silicon single crystal may also be referred to as a neutron irradiated silicon single crystal, however, the phosphorus doped silicon single crystal may be produced using any doping process providing the phosphorus doped silicon single crystal of the invention.

The phosphorus doped silicon single crystal may be prepared from any silicon single crystal, and in the context of the invention, especially in the context of the method of the invention, the silicon single crystal before neutron irradiation may also be referred to as a "silicon ingot" or to a "a gas doped silicon single crystal"; in general a silicon ingot and a gas doped silicon single crystal are thus also considered to be silicon single crystals. For the NTD processing the gas doped silicon single crystal, or silicon ingot, will be cut into a length appropriate for the NTD apparatus. The length will typically be in the range of 50 mm to 600 mm, however, it is also contemplated that a NTD apparatus may be designed for longer silicon single crystals or shorter silicon single crystals. For example, the phosphorus doped silicon single crystal may have an axial length in the range of 20 mm to 1000 mm.

The phosphorus doped silicon single crystal, and also the silicon ingot, will typically be round and have a diameter. The term "diameter" may be used in the context of the silicon single crystal, whether irradiated or not, or a wafer cut from the phosphorus doped silicon single crystal. The wafer will normally be cut at an angle perpendicular to the length of the phosphorus doped silicon single crystal, i.e. perpendicular to the axial dimension of the phosphorus doped silicon single crystal. Thus, the wafer will represent a plane in the phosphorus doped silicon single crystal, which plane is transverse to the axial dimension of the phosphorus doped silicon single crystal. The diameter may also be referred to as a transverse diameter.

The phosphorus doped silicon single crystal is used to prepare wafers for use in the field of electronics. Since the wafer is cut from a silicon single crystal the wafer will be a silicon wafer, and in the context of the invention the two terms can be used interchangeably. Thus, a "wafer" is considered to be a "silicon wafer" even though it may not explicitly be referred to as a silicon wafer. A wafer may be supplied to a user in any form appropriate. Thus, the wafer may be supplied as cut from the phosphorus doped silicon single crystal, or it may be subjected to any further processing, e.g. a high temperature annealing or any polishing or etching or the like as desirable.

A wafer will have a resistivity, which can be measured after annealing as described above. In the context of the invention the phosphorus doped silicon single crystal has a "target resistivity" that is abbreviated "$\rho_{NTD}$" regardless of how the phosphorus doped silicon single crystal has been prepared. The target resistivity, $\rho_{NTD}$, will be a single value for the phosphorus doped silicon single crystal and wafers cut from the phosphorus doped silicon single crystal. However, due to the actual doping process employed the actual resistivity of the wafer will vary over the surface of the wafer and the wafer will have an average resistivity "$\rho_{av}$", which is calculated based on at least 5 resistivity values recorded across the surface of the silicon wafer, in particular 9 resistivity values recorded according to the SEMI standard SEMI MF81. The ratio between the target resistivity and the average resistivity, $\rho_{av}/\rho_{NTD}$, is, in the context of the invention, referred to as "the normalised average resistivity". The ratio of a single resistivity measurement may also be normalised to the target resistivity and in this case it can be referred to as "$\rho/\rho_{NTD}$".

In the method of the invention the resistivity of the silicon material can be controlled by including dopant atoms into the silicon. In the context of the invention the "dopant atoms" will be phosphorus, and in the context of the invention phosphorus atoms may also be referred to as "donor atoms". However, it is also contemplated that the density of boron atoms may be controlled.

The application employs the unit "$cm^{-3}$" for concentrations and densities of atoms, and in the context of the invention it is understood that the unit $cm^{-3}$ refers to atoms·$cm^{-3}$.

**Example 1**

A phosphorus doped silicon single crystal with a target resistivity ($\rho_{NTD}$) of 131 Ωcm and a target diameter of 200 mm was produced in the method of the invention. A silicon single crystal was initially prepared in a float zone (FZ) process as described in WO 2008/125104. Specifically, a silicon single crystal having a diameter of 201 mm was pulled from a polycrystalline rod, with a <100> orientation of the crystal seed using FZ principles. A static magnetic flux density of 0.01 T was applied to the molten zone in a direction essentially parallel to the growth direction of the crystal, and the rotation of the crystal was alternated between clockwise and counter-clockwise rotations of 4 and 6 seconds durations, respectively, at rotational rates of 12 rpm. The change in direction of rotation lasted a maximum of 0.3 s. The movement rate of the rod was 2.8 mm/min. The gas doped silicon single crystal was irradiated with neutrons to decrease the resistivity to the target resistivity ($\rho_{NTD}$), and the required fluence was calculated from Equation (8) using values of the constants $K_1$, $K_2$ and $K_3$ as determined above: $K_1$ was 2.612·$10^{19}$ Ω$cm^{-1}$, $K_2$ was 4.280·$10^{-6}$ $cm^2$, and $K_3$ was 0.10.

The resulting phosphorus doped silicon single crystal was cut into 98 wafers, which were provided with serial numbers using laser labelling.

Each wafer was polished and annealed at 1100°C before recording resistivity values for the wafers. Resistivity values were recorded according to the SEMI standard SEMI MF81. The RRV values are shown in Figure 1, and the wafers had a normalised average resistivity, $\rho_{av}/\rho_{NTD}$, in the range of 0.96 to 1.04 as depicted in Figure 2 and Figure 4, which also show the measured resistivity values compared to the target resistivity of 131 Ωcm. Evidently, the resistivity values of all wafers are well within 5% from the target resistivity, i.e. $\rho_{av}/\rho_{NTD}$ was in the range of 0.95 to 1.05, even within 4% from the target resistivity, i.e. $\rho_{av}/\rho_{NTD}$ was in the range of 0.96 to 1.04.

As is evident from Figure 1 all wafers had RRV values below 1.8% with a mean RRV of about 1.1%, and moreover the normalised average resistivity values were between 0.96 and 1.04, as evident from Figure 2 and Figure 4, which demonstrates the utility of the method of the invention. The wafer ID's are shown in Figure 1 and Figure 2; the wafers were numbered from the "seed end" and the figures show that there is no systematic variation from wafer 1 to wafer 98, which confirms that the method of the invention provides a phosphorus doped silicon single crystal with an even axial distribution of the phosphorous dopant atoms with no systematic axial variation in the RRV or the normalised resistivity values ($\rho_{av}/\rho_{NTD}$).

**Example 2**

Phosphorus doped silicon single crystals with target resistivities ($\rho_{NTD}$) of 55 Ωcm and 740 Ωcm and target diameters of 200 mm were produced in the method of the invention and as outlined in Example 1. Figure 3 shows box plots of resistivities for wafers cut from the prepared phosphorus doped silicon single crystals, and box plots of the deviations from target resistivities for the wafers are shown in Figure 4. The box plots show the median observation and the "bottom" and the "lid" of the boxes represent the 25% and 75% quantiles, and the extremes in the plots represent the 5% and 95% quantiles. For the silicon single crystal with $\rho_{NTD}$ of 55 Ωcm the sample size was 56 wafers, and for the silicon single crystal with $\rho_{NTD}$ of 740 Ωcm the sample size was 13 wafers. The 98 wafers prepared in Example 1, i.e. with a $\rho_{NTD}$ of 131 Ωcm, are included in the plots.

**Example 3**

A plot of the distribution of RRV values for the wafers analysed in Examples 1 and 2 is shown in Figure 5. The data in Figure 5 is seen to be normal distributed, which is generally considered relevant for phosphorus doped silicon single crystals. The plot shows that all wafers analysed (N=168) had RRV values below 1.8% despite the different target resistivities. The distribution had a mean RRV of 1.02, and the standard deviation was 0.26 so that the value of 1.8% corresponded to the average plus three standard deviations.

**Claims**

1. A phosphorus doped silicon single crystal having a diameter in the range of 175 mm to 225 mm, an axial length in the range of 50 mm to 1000 mm and an oxygen content below $2 \cdot 10^{16}$ cm$^{-3}$, the phosphorus doped silicon single crystal in a transverse plane having a density of dopant atoms providing a target resistivity, $\rho_{NTD}$, in the range of 55 $\Omega$cm to 2000 $\Omega$cm for a wafer cut from the phosphorus doped silicon ingot, wherein a RRV value of 2% or less as determined according to the SEMI standard SEMI MF81 is obtained for at least 75% of wafers cut from the phosphorus doped silicon single crystal when the resistivity is measured after annealing the silicon at a temperature in the range of 800°C to 1300°C.

2. The phosphorus doped silicon single crystal according to claim 1, wherein a RRV value of 2% or less is obtained for at least 10 wafers cut from the phosphorus doped silicon single crystal.

3. The phosphorus doped silicon single crystal according to claim 1 or 2, wherein the target resistivity is in the range of 100 $\Omega$cm to 1200 $\Omega$cm.

4. The phosphorus doped silicon single crystal according to any one of claims 1 to 3, wherein 5 or more resistivity values recorded across the surface of the silicon wafer after annealing provide an average resistivity $\rho_{av}$ and the normalised average resistivity defined as $\rho_{av}/\rho_{NTD}$ is in the range of 0.95 to 1.05.

5. The phosphorus doped silicon single crystal according to claim 4, wherein the normalised average resistivity, $\rho_{av}/\rho_{NTD}$, is in the range of 0.95 to 1.05 for at least 10 wafers cut from the phosphorus doped silicon single crystal.

6. The phosphorus doped silicon single crystal according to claim 4 or 5, wherein the normalised average resistivity, $\rho_{av}/\rho_{NTD}$, is in the range of 0.95 to 1.05 for at least 75% of the wafers cut from the phosphorus doped silicon single crystal.

7. The phosphorus doped silicon single crystal according to any one of claims 1 to 6, wherein a plurality of wafers cut from the phosphorus doped silicon single crystal has an upper specific limit, USL, of 4% or less for the RRV, wherein the USL is defined as the average RRV plus 3 standard deviations for the plurality of wafers.

8. A plurality of wafers cut from a phosphorus doped silicon single crystal according to any one of claims 1 to 7, wherein each wafer of the plurality of wafers has a diameter in the range of 175 mm to 225 mm, an oxygen content below $2 \cdot 10^{16}$ cm$^{-3}$, and a RRV value of 2% or less as determined according to the SEMI standard SEMI MF81 when the resistivity is measured after annealing the silicon at a temperature in the range of 800°C to 1300°C.

9. The plurality of wafers according to claim 8, wherein the plurality of wafers has an USL of 5% and a lower specific limit, LSL, of -5% for the normalised average resistivity, $\rho_{av}/\rho_{NTD}$, wherein the USL is defined as plus 3 standard deviations for the plurality of wafers and the LSL is defined as minus 3 standard deviations for the plurality of wafers.

10. The plurality of wafers according to any one of claims 8 or 9, which plurality of wafers has been annealed at a temperature in the range of 800°C to 1300°C.

11. A method of producing a phosphorus doped silicon single crystal having a predetermined target resistivity, $\rho_{NTD}$, in the range of 5 $\Omega$cm to 2000 $\Omega$cm, the method comprising the steps of:

gas doping of molten silicon in a crucible free process or in a crucible in the presence of a phosphorus containing gaseous species,
solidifying the molten silicon so as to form a gas doped silicon single crystal having a pre-irradiation resistivity, $\rho_i$, and a diameter in the range of 175 mm to 225 mm,
irradiating the gas doped silicon single crystal with neutrons to decrease the resistivity to the target resistivity, $\rho_{NTD}$,
wherein the target resistivity, $\rho_{NTD}$, is selected and the gas doping conditions and the irradiation conditions are pre-selected according to the equation:

$$\rho_{NTD} = \rho_i \left( \frac{K_3}{K_2 K_1 \mu_m q} + 1 \right)^{-1}$$

where $\mu_m$ is the electron mobility in silicon and $q$ is electronic charge,
where $K_1$ is a material constant defined as:

$$K_1 = \frac{1}{N^{30Si}\sigma^{30Si}\mu_m q}$$

where $N^{30Si}$ is the density of $^{30}$Si in the silicon and $\sigma^{30Si}$ is the absorption cross-section of $^{30}$Si,
where $K_2$ is a constant for a NTD apparatus defined as:

$$K_2 = \frac{(n_{NTD.e} - n_{i,e}) - (n_{NTD,c} - n_{i,c})}{D}$$

and $K_3$ is a constant for a gas based doping process defined as:

$$K_3 = \frac{n_{i,c} - n_{i,e}}{n_{i,AVG}}$$

where in the definitions of $K_2$ and $K3$, $n_{NTD,e}$ and $n_{NTD,c}$ are the phosphorus donor densities obtainable at the edge and the centre after irradiation, respectively, $D$ is the irradiation dose, and $n_{i,e}$ and $n_{i,c}$ are the phosphorus donor densities obtainable in the gas based doping process at the edge and the centre, respectively.

12. The method according to claim 11 further comprising the step of determining the constant $K_2$ for a NTD reactor and/or determining the constant $K_3$ for a gas doping process.

13. The method according to claim 11 or 12, wherein the gas doping of molten silicon is performed in a crucible and wherein the gas doped silicon single crystal is cut into the subsections of predefined resistivity and a length in the range of 50 mm to 1000 mm before exposing each subsection to irradiation with neutrons.

14. The method according to any one of claims 11 to 13 further comprising the step of cutting a wafer from the phosphorus doped silicon single crystal.

15. The method according to claim 14 further comprising the step of annealing the wafer at a temperature in the range of 800°C to 1300°C.

**Patentansprüche**

1. Phosphordotierter Siliciumeinkristall mit einem Durchmesser im Bereich zwischen 175 mm und 225 mm, einer axialen Länge im Bereich zwischen 50 mm und 1000 mm und einem Sauerstoffgehalt unter $2 \cdot 10^{16}$ cm$^{-3}$, wobei der phosphordotierte Siliciumeinkristall in einer Querebene eine Dichte von Dotierungsatomen aufweist, die für einen spezifischen elektrischen Zielwiderstand, $\rho_{NTD}$, im Bereich zwischen 55 $\Omega$cm und 2000 $\Omega$cm für einen aus dem phosphordotierten Silicium-Ingot geschnittenen Wafer sorgen, wobei ein RRV-Wert für die Schwankung des radialen spezifischen elektrischen Widerstands von maximal 2%, ermittelt gemäß der SEMI-Norm SEMI MF81, für mindestens 75% von aus dem phosphordotierten Siliciumeinkristall geschnittenen Wafern erhalten wird, wenn der spezifische elektrische Widerstand nach dem Tempern des Siliciums bei einer Temperatur im Bereich zwischen 800°C und 1300°C gemessen wird.

2. Phosphordotierter Siliciumeinkristall nach Anspruch 1, wobei ein RRV-Wert von maximal 2% für mindestens 10 aus dem phosphordotierten Siliciumeinkristall geschnittene Wafer erhalten wird.

3. Phosphordotierter Siliciumeinkristall nach Anspruch 1 oder 2, wobei der spezifische elektrische Zielwiderstand im Bereich zwischen 100 $\Omega$cm und 1200 $\Omega$cm liegt.

4. Phosphordotierter Siliciumeinkristall nach einem der Ansprüche 1 bis 3, wobei über die Oberfläche des Siliciumwafers nach dem Tempern aufgezeichnete 5 oder mehr Werte für den spezifischen elektrischen Widerstand einen durch-

schnittlichen spezifischen elektrischen Widerstand $\rho_{av}$ liefern und der normalisierte durchschnittliche spezifische elektrische Widerstand, der als $\rho_{av}/\rho_{NTD}$ definiert ist, im Bereich zwischen 0,95 und 1,05 liegt.

5. Phosphordotierter Siliciumeinkristall nach Anspruch 4, wobei der normalisierte durchschnittliche spezifische elektrische Widerstand, $\rho_{av}/\rho_{NTD}$, für mindestens 10 aus dem phosphordotierten Siliciumeinkristall geschnittene Wafer im Bereich zwischen 0,95 und 1,05 liegt.

6. Phosphordotierter Siliciumeinkristall nach Anspruch 4 oder 5, wobei der normalisierte durchschnittliche spezifische elektrische Widerstand, $\rho_{av}/\rho_{NTD}$, für mindestens 75% der aus dem phosphordotierten Siliciumeinkristall geschnittenen Wafer im Bereich zwischen 0,95 und 1,05 liegt.

7. Phosphordotierter Siliciumeinkristall nach einem der Ansprüche 1 bis 6, wobei eine Vielzahl von aus dem phosphordotierten Siliciumeinkristall geschnittenen Wafern eine obere spezifische Grenze, USL, von maximal 4% für den RRV aufweist, wobei die USL als der durchschnittliche RRV plus 3 Standardabweichungen für die Vielzahl von Wafern definiert ist.

8. Vielzahl von aus einem phosphordotierten Siliciumeinkristall nach einem der Ansprüche 1 bis 7 geschnittenen Wafern, wobei jeder Wafer von der Vielzahl von Wafern einen Durchmesser im Bereich zwischen 175 mm und 225 mm, einen Sauerstoffgehalt unter $2 \cdot 10^{16}$ cm$^{-3}$ und einen RRV-Wert von maximal 2%, ermittelt gemäß der SEMI-Norm SEMI MF81, aufweist, wenn der spezifische elektrische Widerstand nach dem Tempern des Siliciums bei einer Temperatur im Bereich zwischen 800°C und 1300°C gemessen wird.

9. Vielzahl von Wafern nach Anspruch 8, wobei die Vielzahl von Wafern eine USL von 5% und eine untere spezifische Grenze, LSL, von -5% für den normalisierten durchschnittlichen spezifischen elektrischen Widerstand, $\rho_{av}/\rho_{NTD}$, aufweist, wobei die USL als plus 3 Standardabweichungen für die Vielzahl von Wafern definiert ist und die LSL als minus 3 Standardabweichungen für die Vielzahl von Wafern definiert ist.

10. Vielzahl von Wafern nach einem der Anspruch 8 oder 9, wobei die Vielzahl von Wafern bei einer Temperatur im Bereich zwischen 800°C und 1300°C getempert wurde.

11. Verfahren zur Herstellung eines phosphordotierten Siliciumeinkristalls mit einem vorgegebenen spezifischen elektrischen Zielwiderstand, $\rho_{NTD}$, im Bereich zwischen 5 $\Omega$cm und 2000 $\Omega$cm, wobei das Verfahren folgende Schritte umfasst:

Gasdotierung von geschmolzenem Silizium in einem tiegellosen Verfahren oder in einem Tiegel in Gegenwart einer phosphorhaltigen gasförmigen Spezies,
Verfestigen des geschmolzenen Siliciums zum Bilden eines gasdotierten Siliciumeinkristalls mit einem spezifischen elektrischen Widerstand vor der Bestrahlung, $\rho_i$, und einem Durchmesser im Bereich zwischen 175 mm und 225 mm,
Bestrahlen des gasdotierten Siliciumeinkristalls mit Neutronen zur Senkung des spezifischen elektrischen Widerstands auf den spezifischen elektrischen Zielwiderstand, $\rho_{NTD}$,
wobei gemäß folgender Gleichung der spezifische elektrische Zielwiderstand, $\rho_{NTD}$, ausgewählt wird, und die Gasdotierungsbedingungen und die Bestrahlungsbedingungen vorausgewählt werden:

$$\rho_{NTD} = \rho_i \left( \frac{K_3}{K_2 K_1 \mu_m q} + 1 \right)^{-1}$$

wobei $\mu_m$ die Beweglichkeit der Elektronen in Silicium ist und $q$ die Elementarladung ist,
wobei $K_1$ eine folgendermaßen definierte Materialkonstante ist:

$$K_1 = \frac{1}{N^{30Si} \sigma^{30Si} \mu_m q}$$

wobei $N^{30Si}$ die Dichte von $^{30}$Si im Silicium ist und $\sigma^{30Si}$ der Absorptionsquerschnitt von $^{30}$Si ist,
wobei $K_2$ eine Konstante für ein NTD-Gerät ist, die definiert ist als:

$$K_2 = \frac{(n_{NTD,e} - n_{i,e}) - (n_{NTD,c} - n_{i,c})}{D}$$

und $K_3$ eine Konstante für ein gasbasiertes Dotierungsverfahren ist, die definiert ist als:

$$K_3 = \frac{n_{i,c} - n_{i,e}}{n_{i,AVG}}$$

wobei in der Definition von $K_2$ und $K_3$ $n_{NTD,e}$ und $n_{NTD,c}$ die Dichte der Phosphordonatoren ist, die sich nach der Bestrahlung am Rand beziehungsweise in der Mitte erhalten lässt, D die Strahlungsdosis ist und $n_{i,e}$ und $n_{i,c}$ die Dichte der Phosphordonatoren ist, die sich im gasbasierten Dotierungsverfahren am Rand beziehungsweise in der Mitte erhalten lässt.

12. Verfahren nach Anspruch 11, ferner umfassend den Schritt des Bestimmens der Konstante $K_2$ für einen NTD-Reaktor und/oder Bestimmen der Konstante $K_3$ für ein Gasdotierungsverfahren.

13. Verfahren nach Anspruch 11 oder 12, wobei die Gasdotierung von geschmolzenem Silicium in einem Tiegel durchgeführt wird und wobei der gasdotierte Siliciumeinkristall in die Teilabschnitte mit vorgegebenem spezifischen elektrischen Widerstand und einer Länge im Bereich zwischen 50 mm und 1000 mm geschnitten wird, bevor jeder Teilabschnitt mit Neutronen bestrahlt wird.

14. Verfahren nach einem der Ansprüche 11 bis 13, ferner umfassend den Schritt des Schneidens eines Wafers aus dem phosphordotierten Siliciumeinkristall.

15. Verfahren nach Anspruch 14, ferner umfassend den Schritt des Temperns des Wafers bei einer Temperatur im Bereich zwischen 800°C und 1300°C.

**Revendications**

1. Monocristal de silicium dopé au phosphore ayant un diamètre dans la plage de 175 mm à 225 mm, une longueur axiale dans la plage de 50 mm à 1000 mm et une teneur en oxygène inférieure à $2 \cdot 10^{16}$ cm$^{-3}$, le monocristal de silicium dopé au phosphore dans un plan transversal ayant une densité d'atomes dopants fournissant une résistivité cible, $\rho_{NTD}$, dans la plage de 55 $\Omega$cm à 2000 $\Omega$cm pour une tranche découpée dans le lingot de silicium dopé au phosphore, une valeur de VRR (variation de résistivité radiale) de 2 % ou moins telle que déterminée selon la norme SEMI SEMI MF81, étant obtenue pour au moins 75 % des tranches découpées dans le monocristal de silicium dopé au phosphore lorsque la résistivité est mesurée après recuit du silicium à une température dans la plage de 800 °C à 1300 °C.

2. Monocristal de silicium dopé au phosphore selon la revendication 1, une valeur de VRR de 2 % ou moins étant obtenue pour au moins 10 tranches découpées dans le monocristal de silicium dopé au phosphore.

3. Monocristal de silicium dopé au phosphore selon la revendication 1 ou 2, la résistivité cible étant dans la plage de 100 $\Omega$cm à 1200 $\Omega$cm.

4. Monocristal de silicium dopé au phosphore selon l'une quelconque des revendications 1 à 3, 5 valeurs de résistivité ou plus enregistrées sur la surface de la tranche de silicium après recuit fournissant une résistivité moyenne $\rho_{av}$ et la résistivité moyenne normalisée définie comme $\rho_{av}/\rho_{NTD}$ étant dans la plage de 0,95 à 1,05.

5. Monocristal de silicium dopé au phosphore selon la revendication 4, la résistivité moyenne normalisée, $\rho_{av}/\rho_{NTD}$, étant dans la plage de 0,95 à 1,05 pour au moins 10 tranches découpées dans le monocristal de silicium dopé au phosphore.

6. Monocristal de silicium dopé au phosphore selon la revendication 4 ou 5, la résistivité moyenne normalisée, $\rho_{av}/\rho_{NTD}$, étant dans la plage de 0,95 à 1,05 pour au moins 75 % des tranches découpées dans le monocristal de silicium dopé au phosphore.

7. Monocristal de silicium dopé au phosphore selon l'une quelconque des revendications 1 à 6, une pluralité de tranches découpées dans le monocristal de silicium dopé au phosphore ayant une limite spécifique supérieure, USL, de 4 % ou moins pour la VRR, l'USL étant définie comme la VRR moyenne plus 3 écarts types pour la pluralité de tranches.

8. Pluralité de tranches découpées dans un monocristal de silicium dopé au phosphore selon l'une quelconque des revendications 1 à 7, chaque tranche de la pluralité de tranches ayant un diamètre dans la plage de 175 mm à 225 mm, une teneur en oxygène inférieure à $2 \cdot 10^{16}$ cm$^{-3}$, et une valeur de VRR de 2 % ou moins, telle que déterminée selon la norme SEMI SEMI MF81, lorsque la résistivité est mesurée après recuit du silicium à une température dans la plage de 800 °C à 1300 °C.

9. Pluralité de tranches selon la revendication 8, la pluralité de tranches ayant une USL de 5 % et une limite spécifique inférieure, LSL, de -5 % pour la résistivité moyenne normalisée, $\rho_{av}/\rho_{NTD}$, l'USL étant définie comme plus 3 écarts types pour la pluralité de tranches et la LSL étant définie comme moins 3 écarts types pour la pluralité de tranches.

10. Pluralité de tranches selon l'une quelconque des revendications 8 ou 9, laquelle pluralité de tranches a été recuite à une température dans la plage de 800 °C à 1300 °C.

11. Procédé de production d'un monocristal de silicium dopé au phosphore ayant une résistivité cible prédéterminée, $\rho_{NTD}$, dans la plage de 5 $\Omega$cm à 2000 $\Omega$cm, le procédé comprenant les étapes de :

dopage au gaz du silicium fondu dans un procédé sans creuset ou dans un creuset en présence d'une espèce gazeuse contenant du phosphore,
solidification du silicium fondu de manière à former un monocristal de silicium dopé au gaz ayant une résistivité de pré-irradiation, $\rho_i$, et un diamètre dans la plage de 175 mm à 225 mm,
irradiation du monocristal de silicium dopé au gaz par des neutrons pour diminuer la résistivité à la résistivité cible, $\rho_{NTD}$,
la résistivité cible, $\rho_{NTD}$, étant sélectionnée et les conditions de dopage de gaz et les conditions d'irradiation étant présélectionnées selon l'équation :

$$\rho_{NTD} = \rho_i \left( \frac{K_3}{K_2 K_1 \mu_m q} + 1 \right)^{-1}$$

où $\mu_m$ est la mobilité des électrons dans le silicium et $q$ est la charge électronique,
où $K_1$ est une constante de matériau définie comme :

$$K_1 = \frac{1}{N^{30Si} \sigma^{30Si} \mu_m q}$$

où $N^{30Si}$ est la densité de $^{30}$Si dans le silicium et $\sigma^{30Si}$ est la section d'absorption de $^{30}$Si,
où $K_2$ est une constante pour un appareil NTD défini comme :

$$K_2 = \frac{\left(n_{NTD.e} - n_{i,e}\right) - \left(n_{NTD,c} - n_{i,c}\right)}{D}$$

et $K_3$ est une constante pour un procédé de dopage à base de gaz défini comme :

$$K_3 = \frac{n_{i,c} - n_{i,e}}{n_{i,AVG}}$$

où dans les définitions de $K_2$ et $K_3$, $n_{NTD,e}$ et $n_{NTD,c}$ sont les densités de donneurs de phosphore pouvant être obtenues, respectivement au bord et au centre après irradiation, D est la dose d'irradiation, et $n_{i,e}$ et $n_{i,c}$ sont les densités de donneurs de phosphore pouvant être obtenues dans le processus de dopage au gaz, respectivement au bord et au centre.

12. Procédé selon la revendication 11 comprenant en outre l'étape de détermination de la constante $K_2$ pour un réacteur NTD et/ou de détermination de la constante $K_3$ pour un procédé de dopage au gaz.

13. Procédé selon la revendication 11 ou 12, le dopage au gaz de silicium fondu étant effectué dans un creuset et le monocristal de silicium dopé au gaz étant découpé dans les sous-sections de résistivité prédéfinie et d'une longueur dans la plage de 50 mm à 1000 mm avant exposition de chaque sous-section à une irradiation par des neutrons.

14. Procédé selon l'une quelconque des revendications 11 à 13, comprenant en outre l'étape de découpage d'une tranche dans le monocristal de silicium dopé au phosphore.

15. Procédé selon la revendication 14 comprenant en outre l'étape de recuit de la tranche à une température dans la plage de 800 °C à 1300 °C.

Fig. 1

Fig. 2

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 102010028924
- DE 102004034372
- WO 2008125104 A
- DK 177854
- US 2003024469 A
- EP 2824222 A
- US 2015240380 A

### Non-patent literature cited in the description

- International Atomic Energy Agency. *IAEA-TEC-DOC-1681,* 2012, ISBN 978-92-0-130010-2
- Neutron Transmutation Doped (NTD) Silicon For High Power Electronics. *Topsil Semiconductor Materials' Application Note,* October 2013, ht-tp://www.topsil.com/media/56052/ntd application note long version october 2013.pdf
- *13th European Conference on Power Electronics and Applications,* 2009, 1-10
- **PARK et al.** *Neutron transmutation doping in HANARO reactor,* 2013, ht-tp://www-pub.iaea.org/MTCD/Publications/PDF/SupplementaryMaterials/TECDOC 1713 CD /template-cd/datasets/papers/Park-SJ%20NTD%20Silicon%20HANARO%20Jun2010. pdf